# EUROPEAN PATENT APPLICATION

(11) **EP 2 172 754 A1**
(43) Date of publication of application: **07.04.2010**
(21) Application number: 08017465.9
(22) Date of filing: 06.10.2008
(51) Int. Cl.: G01J 5/02, G01J 5/04, G01J 5/12, B81B 7/00

(54) **Infrared sensor with back side infrared filter**

(71) Applicant: Sensirion AG, 8712 Stäfa (CH)
(72) Inventor: Streiff, Matthias, 8006 Zürich (CH); Sunier, Robert, 8046 Zürich (CH); Mayer, Felix, 8712 Stäfa (CH)
(74) Representative: Sutter, Kurt

(57) **Abstract**

An infrared sensor comprises a temperature sensor (4) at a top side of a substrate (1) and an infrared filter element (19) located at a bottom side of the substrate (1). A lead frame is placed above the substrate (1) and a housing is cast having a window (42) extending to the filter element (19). A recess (27) in the lead frame (25) provides a large distance between the temperature sensor (4) and the metal of the lead frame (25), thereby reducing thermal conductance. This type of device is easy to manufacture.

## Description

The invention relates to an infrared sensor comprising a temperature sensor arranged on a membrane and an infrared filter, as well as to a manufacturing method of such a sensor.

Infrared sensors for measuring radiation in the spectral range between 800 nm and 20 µm have a variety of applications, such as for contact-less temperature measurement as well as infrared spectroscopy.

A sensor of this type is described in DE 10 2004 002 163. It comprises a temperature sensor arranged on a membrane at the top side of a substrate. A bandpass filter plate is mounted above the temperature sensor. Infrared light passing through the bandpass filter reaches the temperature sensor and heats it up, which allows to measure the amount of light. The substrate is located on top of a lead frame. A housing is cast around this assembly. The housing has a top side window extending to the filter.

The problem to be solved by the present invention is to provide a sensor of this type that is easy to manufacture, as well as a corresponding manufacturing method.

This problem is solved by the sensor and the method according to the independent claims.

Accordingly, the filter member is not arranged above the temperature sensor, but rather below the temperature sensor.

This simplifies the manufacturing process because the filter element can be mounted from the bottom side of the substrate. The bottom side of the substrate can be accessed easily and does not contain any sensitive components.

In an advantageous embodiment, the filter element is arranged at the bottom side of the substrate. In this case the substrate acts as a spacer that keeps the filter plate at a distance of, typically, several 100 µm from the temperature sensor, thereby improving the thermal insulation of the temperature sensor.

Advantageously, the sensor further comprises a lead frame, and the lead frame is located at the top of the substrate (i.e. at the side of the temperature sensor), which places the contact pads of the substrate right to the leads of the lead frame.

Other advantageous embodiments are described in the dependent claims as well as in the following description. The description refers to the enclosed figures, wherein:
Fig. 1 is a top view of a first embodiment of a core sensor,
Fig. 2 is a sectional view along line II-II of Fig. 1,
Fig. 3 is a sectional view along line III-III of Fig. 1,
Fig. 4 is a sectional view of a second embodiment of a core sensor, corresponding to the view of Fig. 3,
Fig. 5 is a first embodiment of an infrared sensor based on the first core sensor,
Fig. 6 is a second embodiment of an infrared sensor based on the second core sensor,
Fig. 7 is a sectional view of the sensor of Fig. 5 with a lead frame,
Fig. 8 is a sectional view of the sensor of Fig. 7 while casting the housing,
Fig. 9 is the resulting sensor of the casting process of Fig. 8, and
Fig. 10 is an alternative to the embodiment of Fig. 7 using flip-chip bonding.

### Definitions:

Terms of the type "up", "top", "above" and "over", as well as "down", "bottom", "beneath" and "below" refer an orientation of sensor where the membrane and temperature sensor are on the top side thereof. In other words, the membrane and the temperature sensor define the top side of the substrate and the direction between the membrane side of the substrate and the opposite side of the substrate is the top down direction.

An "infrared bandpass filter" is a filter that allows transmission of part of the infrared spectrum. Such filters can be broad or narrow and they e.g. include interference filters.

The statement "a temperature sensor is arranged on the membrane" is to be understood such that the temperature sensor can be arranged on top of, within or below the membrane and is mechanically connected to and held by the membrane.

### The core sensor:

The present sensor is based on a "core sensor" comprising a substrate, a membrane mounted to the top side of the substrate, and a temperature sensor arranged on the membrane. This type of device is known to the skilled person. Its purpose is to suspend the temperature sensor in such a manner that it is thermally well insulated and allows to detect a temperature change even for low intensity infrared light.

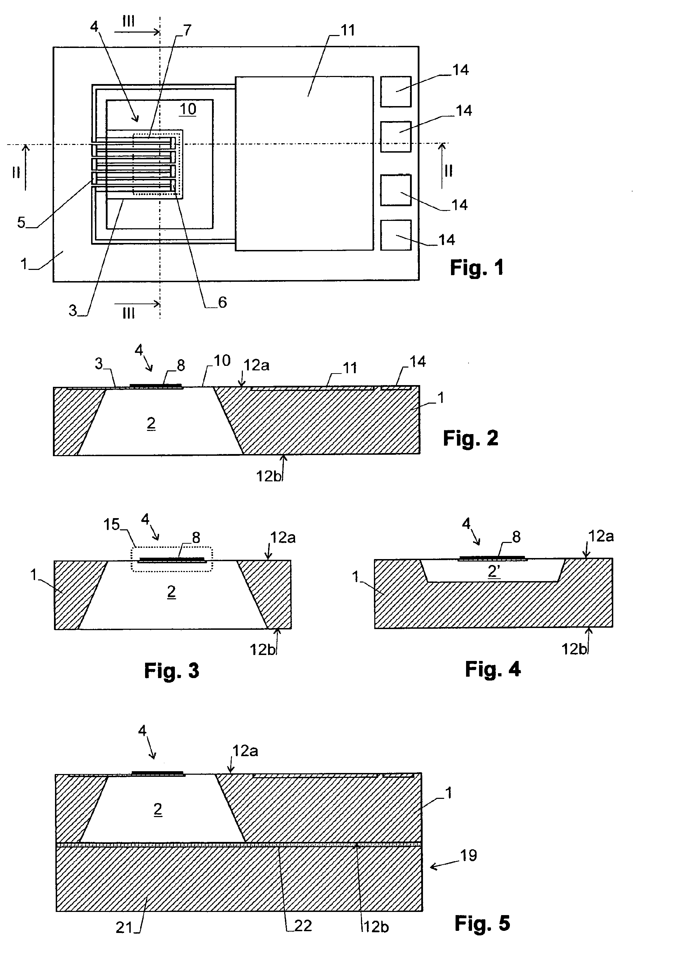

A first embodiment of such a core sensor is shown in Figs. 1 - 3. It comprises a substrate 1. Substrate 1 has an opening 2 formed therein, which has e.g. been manufactured by anisotropic etching. A membrane 3 is arranged over opening 2. Membrane 3 has e.g. been formed by applying one or more dielectric layers to the top of substrate 2 prior to etching opening 2.

A temperature sensor 4 is arranged on membrane 3. In the embodiment shown here, temperature sensor 4 is formed by a thermopile comprising a plurality of thermoelements having a first and a second series of junctions 5, 6 connected by leads 7 of two different types of materials, such as polysilicon and metal. The first series 5 of junctions is arranged over the bulk of substrate 1, while the second series 6 of junctions, which corresponds to temperature sensor 4, is located on membrane 3 above opening 2. Thus, the thermopile basically generates a voltage dependent on the temperature difference between the locations of the second series 6 of junctions on membrane 3 and the first series 5 of junctions on substrate 1. This type of arrangement is generally known to the skilled person. By way of example, we refer to EP 1 840 535, which shows a similar structure used for a flow sensor.

As the thermopile measures merely the temperature difference between its two contact rows 5, 6, it can be advantageous to provide, in addition thereto, an absolute temperature sensor, such as a band gap temperature sensor, on substrate 1.

Alternatively to using a thermopile, any other suitable type of temperature sensor, such as a resistive sensor, can be used as well.

An infrared absorber layer 8 is mounted to the top of membrane 3, covering at least the second series 6 of junctions. Its purpose is to increase the absorption of the incoming infrared light and to thereby increase the efficiency of the device. Absorber layer 8 can e.g. be a metal layer, such as aluminum.

As can be seen from Fig. 1, membrane 3 advantageously does not cover all of opening 2, but extends in tongue-like fashion from one side thereof. Hence, a gap 10 is formed on three sides of membrane 3, further increasing its thermal insulation.

Advantageously, substrate 1 is a semiconductor substrate, in particular a silicon substrate. Thus, it can carry integrated circuitry 11, advantageously at its top side 12a, such as amplifiers, analog/digital converters and digital circuitry.

Furthermore, a plurality of bond pads 14 is arranged on top side 12a of substrate 1. They serve to connect circuitry 11 and/or temperature sensor 4 to external devices.

Optionally, temperature sensor 4 can be insulated against heat transfer by means of an insulating coating, in particular an insulation layer of a nanoporous material, as indicated in dotted lines by reference numeral 15 in Fig. 3. This type of material, which consists of a solid having a large volume fraction of pores of sub-micrometer size, is known to reduce thermal conductance by limiting the path length of gas molecules. A description of such materials as well as of the related manufacturing methods can e.g. be found in EP 1 772 717. Such an insulation can be added to any of the infrared sensors described below - it is useful even if temperature sensor 4 is placed in a vacuum cavity because it still is able to reduce thermal conductance effects due to residual gas molecules.

Insulating material 15 should be transparent for the infrared light to be measured.

A second embodiment of a core sensor is shown in Fig. 4. It differs from the one of Figs. 1 - 3 only by the fact that a recess 2' is provided in the top side 12a of substrate 1 instead of opening 2. Recess 2' can e.g. also be formed by anisotropic etching, but the etching process takes place from the top side 12a and is stopped when recess 2' has reached the desired depth.

The core sensor of Figs. 1 - 4 can mostly be manufactured e.g. using standard CMOS-processes. Only the formation of opening 2 or recess 2' is carried out separately, e.g. using a special etching step as described above.

### The infrared sensor:

Even though the core sensor as described above is basically able to operate as an infrared sensor, in the context of the present invention an infrared filter is added to the core sensor for improved selectivity. Furthermore, the sensor can be packaged in a suitable housing.

### Embodiment 1

The first embodiment, as shown in Fig. 5, is based on the core sensor described in reference to Figs. 1 - 3. It comprises a filter element or filter plate 19 located at the bottom side 12b of substrate 1.

Filter element 19 comprises an infrared bandpass filter. In the present embodiment, it is formed by a carrier layer 21 and a filter layer 22.

Carrier layer 21 is made of an IR-transparent material, such as silicon, and provides mechanical stability to filter element 19.

Filter layer 22 is e.g. a single- or multilayer structure comprising several infrared-transparent layers of differing refractive index, such as layers of Ge, Si, and MgF₂, and forms the filter having the filtering properties as desired. This type of filters is known to the skilled person.

Filter element 19 is mounted to substrate 1 with filter layer 22 facing substrate 1. Thus, filter layer 22 is protected from mechanical wear and/or pollution.

Filter element 19 has the form of a flat plate. Its distance from the temperature sensor 4 corresponds to the thickness of substrate 1 and can therefore easily be several 100 µm without adding additional volume to the device.

To use the device of Fig. 5, IR radiation is received through filter element 19 and impinges on temperature sensor 4, where the corresponding increase of temperature can be measured.

### Embodiment 2

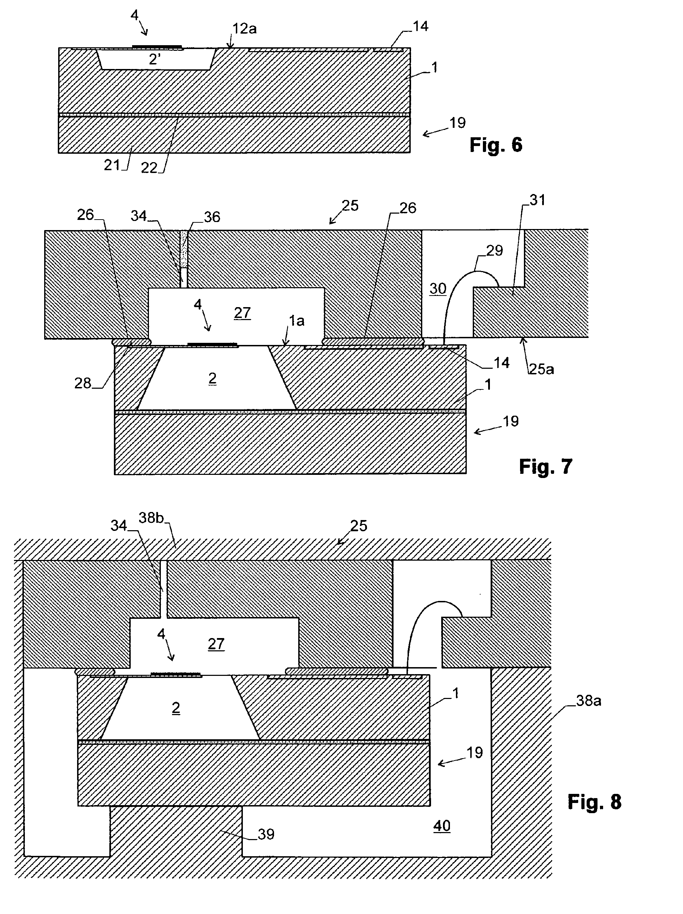

A second embodiment of an infrared sensor based on the second embodiment of the core sensor according to Fig. 4 is shown in Fig. 6. As can be seen, the design of this sensor is basically identical to the one of Fig. 5, with the exception of opening 2 being replaced by recess 2'. Again, filter element 19 is mounted to bottom side 12b of substrate 1.

Alternatively, filter element 19 can also consist of filter layer 22 only, without carrier layer 21. Filter layer 22 can e.g. be directly deposited to bottom side 12b of substrate 1 using a coating process. or carrier layer 21 can be removed by grinding and/or etching.

### Manufacturing process:

Manufacturing the sensors of Fig. 5 and 6 advantageously starts by providing the core sensor, e.g. the sensor shown in Figs. 1 - 3 or Fig. 4 above. This core sensor can e.g. be formed, as described, by means of a standard CMOS process with subsequent etching in order to form opening 2 or recess 2'.

Typically, an assembly consisting of a plurality of the core sensors is provided on a wafer. This wafer will be called the "base wafer" in the following.

Filter element 19 is advantageously mounted by attaching a "filter wafer" to the bottom side of the base wafer prior to dicing the same. The filter wafer has the same structure as a single filter plate 19, but has substantially the same lateral extension as the base wafer. Hence, all sensors of the sensor assembly can be provided with a filter element in a single step. The filter wafer advantageously comprises a silicon wafer with filter layer 22 applied to its top side.

The filter wafer can e.g. be glued or bonded to the bottom side of the base wafer.

Subsequently, the sensor assembly with the attached filter wafer is cut (diced) into the individual infrared sensors.

### Lead frame:

The sensor of any of the above embodiments can be mounted to a metal lead frame 25 as shown in Fig. 7.

The bottom side 25a of lead frame 25 comprises an attachment region 26 and a recess 27. Attachment region 26 is substantially flat and is attached to substrate 1, e.g. by means of a die attach 28. Recess 27 is set back in respect to the attachment region 26 and is arranged above temperature sensor 4, such that it forms a dome over temperature sensor 4. This allows to keep the distance between temperature sensor 4 and the metal parts of lead frame 25 large, thereby improving the thermal insulation of the temperature sensor.

As further shown in Fig. 7, the contact pads 14 of substrate 1 are connected to the leads of lead frame 25 by means of bond wires 29. The bond wires 29 extend from contact pad 14 through a window 30 in lead frame 26 and are attached to the top side of ledges 31 of lead frame 25. This design allows to attach the bond wires 29 through the window 30 after mounting substrate 1 to lead frame 25.

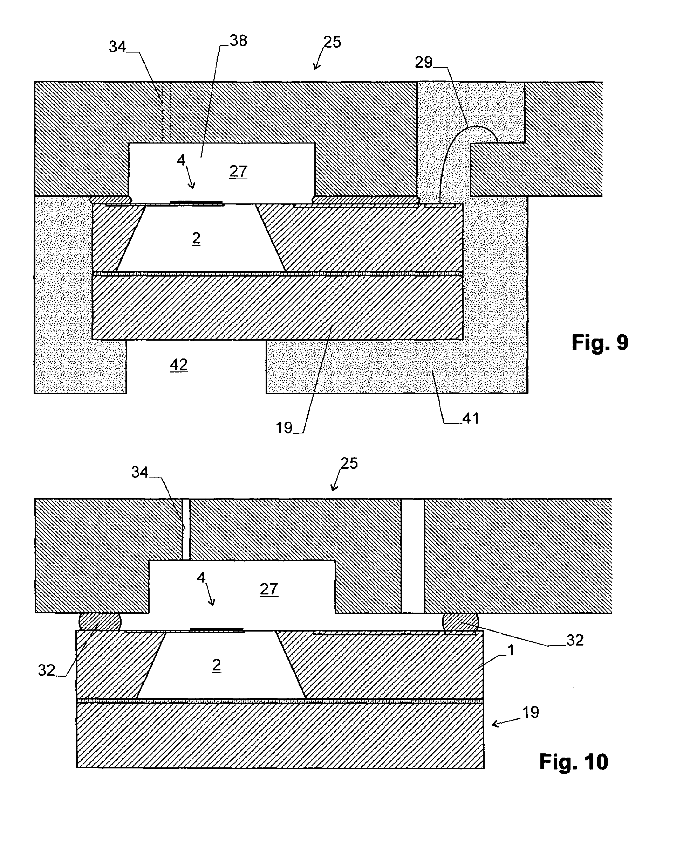

Alternatively, and as shown in Fig. 10, substrate 1 can be flip-chip bonded to lead frame 25. In this case, gold bumps, ACF (anisotropic conductive films) or solder bumps 32 can be arranged between the bond pads 14 and the leads of lead frame 25.

Fig. 9 further shows an optional opening 34 extending through lead frame 25 at the location of recess 27. It communicates with recess 27, i.e. it communicates with temperature sensor 4 and provides airing for the cavity of the temperature sensor. Optionally, opening 34 can be blocked by a gas-permeable particle filter 36. In the embodiment of Fig. 7, particle filter 36 is schematically depicted to be located within opening 34, but it may also be located at the top or bottom end thereof. It prevents dirt and, advantageously, liquid from entering the cavity.

If opening 34 is omitted and a gas-tight bond between substrate 1 and lead frame 25 is used, the cavity 38 where temperature sensor 4 is located and which is formed by recess 27 and opening 2 can be evacuated for improved thermal insulation. If the core sensor of Figs. 1 - 3 is used, a gas-tight bonding is, in that case, also required between substrate 1 and filter element 19 because filter element 19 forms the bottom of cavity 38. If the core sensor of Fig. 4 is used, substrate 1 itself forms the bottom of cavity 38, and therefore no additional bonding between substrate 1 and filter element 19 is required. In both cases, cavity 38 is covered by lead frame 25.

### Packaging:

The device of Fig. 7 is advantageously provided with a housing by placing it into a mold 38a, 38b as shown in Fig. 8. The mold comprises a bottom part 38a, which has a projection 39 that abuts against the bottom side of filter element 19 at the location of temperature sensor 4. The mold further comprises a top part 38b, which rests on top of lead frame 25.

The gap 40 formed within the mold is filled with a hardening material, as it is known by the person skilled in the art. The hardening material is hardened in order to form a housing that has an opening where projection 39 abutted against filter element 19.

The resulting device is shown in Fig. 9. As can be seen, its housing 41 comprises a window 42 at the former location of projection 39, which allows infrared radiation to enter through filter element 19.

Advantageously, the housing 41 covers at least part of the bottom side of filter element 19, thereby holding the same securely.

### Notes:

As can be seen, the present sensor does not necessarily have to provide a vacuum cavity for thermally insulating temperature sensor 4, primarily because the filter plate 19 as well as the lead frame 25 can easily be kept at a sufficient distance from temperature sensor 4, thereby reducing thermal losses. However, if so desired, a vacuum cavity design may be used as well. In this case, attach 28 must form a hermetical seal, a further hermetic seal is required between substrate 1 and filter element 19, and opening 34 must be closed. To close opening 34, it is e.g. possible to place some solder or glass frit close to opening 34 and then heat up the assembly under vacuum in order to melt the solder or glass frit. Molten solder or glass frit enters opening 34 and hardens to provide a hermetic seal therein.

In the above embodiment, filter element 19 was attached to the sensor prior to casting the housing. Alternatively, the filter element may also be added to the device after casting the housing, as described in DE 10 2004 002 163. This has the advantage that a smaller total area of (expensive) filter elements is required, but in that case the filter elements have to be mounted individually to each sensor.

Alternatively, individual filter elements instead of a filter wafer can be applied to each sensor prior to dicing the base wafer.

The techniques described here can also be applied to infrared sensors that comprise an array of several temperature sensors arranged along a line or along a two-dimensional grid, which e.g. allows the recording of one- or two-dimensional infrared images.

To improve the efficiency of the present device, the filter of the present sensor can be provided with an anti-reflection coating on one or both sides. In particular, if a topmost or bottommost layer of the filter is formed by a highly refractive material, such as silicon, it can be covered by a coating having a lower refractive index. Anti-reflection coatings are known to the skilled person.

If the device comprises a vacuum cavity 28, a getter for adsorbing gas molecules can be placed in the same for improving its vacuum maintaining capabilities. Such getters, which typically consist of a metal layer applied to an inner surface of the cavity under vacuum conditions, are also known to the skilled person.

## Claims

1. An infrared sensor comprising
a substrate (1),
a membrane (3) mounted on a top side of said substrate (1),
a temperature sensor (4) arranged on said membrane (3),
a filter element (19) comprising an infrared filter, in particular a bandpass filter, and being arranged at a distance from said membrane (3) and said temperature sensor (4),
**characterized in that** said filter member (19) is arranged below said temperature sensor (4).

2. The sensor of claim 1 wherein said filter element (19) is arranged at a bottom side of said substrate (1).

3. The sensor of any of the preceding claims further comprising a lead frame (25), wherein said lead frame (25) is arranged at a top side of said substrate.

4. The sensor of claim 3 wherein said lead frame (25) has a bottom side (25a) comprising an attachment region (26) attached to said substrate (1) and a recess (27), wherein said recess (27) is arranged above said temperature sensor (4).

5. The sensor of any of the claims 3 or 4 wherein said substrate (1) comprises contact pads (14) and wherein said sensor comprises bond wires (29) connecting a top side of said lead frame (25) to said contact pads (14), and in particular wherein said bond wires (29) extend through at least one window (30) of said lead frame (25).

6. The sensor of any of the claims 3 or 4 wherein said substrate (1) comprises contact pads (14) flip-chip bonded to said lead frame (25).

7. The sensor of any of the claims 3 to 6, wherein said lead frame (25) comprises an opening (34) communicating with said temperature sensor (4).

8. The sensor of any of the claims 3 to 7 wherein said substrate (1) is connected to said lead frame (25) in gas-tight manner and an evacuated cavity (38) covered by said lead frame (25) is formed for receiving said temperature sensor (4).

9. The sensor of any of the preceding claims wherein said filter element (19) comprises a silicon substrate (21), wherein said filter (22) is arranged on said silicon substrate (21) and in particular wherein said filter element (19) in mounted to said substrate (1) with said filter (22) facing said substrate (1).

10. The sensor of any of the preceding claims further comprising a housing (41) of a cast material, wherein said housing (41) covers part of a bottom surface of said filter element (19) and has a window (42) providing access to the filter element (19).

11. The sensor of any of the preceding claims further comprising a nanoporous insulation layer (15) located at said temperature sensor (4).

12. A method for manufacturing an infrared sensor, in particular for manufacturing the sensor of any of the preceding claims, comprising the steps of
providing a core sensor having a substrate (1) with a membrane (3) mounted to a top side of said substrate (1) and a temperature sensor (4) arranged on said membrane (3),
mounting a filter element (19) comprising an infrared bandpass filter, in particular an interference filter, at a distance from said membrane (3) and said temperature sensor (4),
**characterized in that** said filter element (19) is mounted from a bottom side to said substrate (1).

13. The method of claim 12 further comprising the step of mounting a lead frame (25) on top of said substrate.

14. The method of claim 13 further comprising the steps of
placing said lead frame (25), said core sensor and said filter element (19) in a mold (38a, 38b), wherein said mold (38a, 38b) abuts against at least part of said filter element (19),
filling said mold (38a, 38b) with a hardening material, and
hardening said hardening material in order to form a housing (41) having a window (42) where said mold abutted against said filter element (19).

15. The method of any of the claims 12 to 14 comprising the steps of
providing a plurality of core sensors on a base wafer (30),
mounting a filter wafer (31) to a bottom side of said base wafer, and
separating said sensor assembly into a plurality of said infrared sensors.
